# EUROPÄISCHE PATENTANMELDUNG

(11) **EP 1 414 065 A2**
(43) Veröffentlichungstag der Anmeldung: **28.04.2004**
(21) Anmeldenummer: 03022929.8
(22) Anmeldetag: 09.10.2003
(51) Int. Cl.: H01L 25/07, H01L 23/48

(54) **Leistungsbauelementanordnung zur mechatronischen integration von Leistungsbauelementen**

(30) Priorität: 22.10.2002 DE 10249205
(71) Anmelder: SIEMENS AKTIENGESELLSCHAFT, 80333 München (DE)
(72) Erfinder: Franke, Ralf-Michael, 81541 München (DE)

(57) **Zusammenfassung**

Leistungsbauelementanordnung zur mechatronischen Integration von Leistungsbauelementen, die für die mechatronische Integration verschiedener Leistungsbauelemente in die Applikation geeignet ist, mit einer Mehrzahl von Leistungsbauelementen, insbesondere IGBTs und/oder Leistungsdioden, einer Leiterplatte, auf der die Leistungsbauelemente gehäusefrei angeordnet sind, mindestens einem Kühlkörper zur Wärmeabführung von den Leistungsbauelementen und einem mit dem Kühlkörper verbundenen Druckmontagerahmen, der die auf der Leiterplatte angeordneten Leistungsbauelemente in Wärmeleitkontakt mit dem Kühlkörper hält.

## Beschreibung

Die Erfindung betrifft eine Leistungsbauelementanordnung zur mechatronischen Integration von Leistungsbauelementen.

Elektrische Antriebssysteme werden heute in vielfältiger Form verwendet. Kleinste Leistungen im Mikrowatt-Bereich (Armbanduhr) bis hin zu höchsten Leistungen im Megawatt-Bereich (Lokomotive, Walzwerk) sind nicht ungewöhnlich. Auch die Qualität der Antriebsaufgabe umfasst einen großen Bereich vom einfachen Spielzeugantrieb bis zur anspruchsvollen Lageregelung in der Werkzeugmaschine.

Ein elektrisches Antriebssystem besteht mindestens aus einem Motor, der elektrische Energie etwa aus dem Stromnetz aufnimmt und in Rotationsenergie umwandelt, und ggf. einem Getriebe. Bei größeren Antrieben oder wenn die Antriebsaufgabe anspruchsvoll ist, oder auch wenn nicht immer die maximale Antriebsleistung benötigt wird, werden heute meist geregelte oder drehzahlveränderliche Antriebe verwendet. Bei einem geregelten Antrieb wird der elektrische Motor über ein Leistungsstellglied betrieben, und eine Regelung sorgt dafür, dass gewünschte Prozessgrößen eingehalten werden. Ein elektronisches Leistungsstellglied ist meist als ein Gerät ausgeführt, welches die erforderliche Leistungselektronik sowie die zugehörige Signalverarbeitung enthält. Solche Geräte werden z. B. als "Stromrichter", "Wechselrichter" oder "Umrichter" bezeichnet, womit das gesamte Gerät und nicht nur der Leistungsteil gemeint ist.

Die Leistungselektronik verwendet als Bauelemente Dioden, Thyristoren, Leistungstransistoren und insbesondere für hohe Schaltfrequenzen (bis zu 1MHz) und kleine Spannungen (bis etwa 400V) MOSFETs sowie für große Leistungen mit nicht allzu großen Schaltfrequenzen (3kHz..100kHz) IGBTs (Insulated Gate Bipolar Transistors). IGBTs stehen heute für hohe Spannungen (2kV) und Ströme zur Verfügung. In der Antriebstechnik hat der IGBT in den letzten Jahren eine große Verbreitung gefunden. Wechselrichter zum Betrieb von Asynchron- und Synchronmaschinen im Leistungsbereich von wenigen 100W bis in den MW-Bereich werden heute fast ausschließlich mit IGBTs realisiert.

Die Leistungsbauelemente werden in Modulen angeordnet, die Einzelschalter oder auch integrierte Schaltungsanordnungen enthalten können. Die Aufbau- und Verbindungstechnik der Module muss die erforderliche elektrische Isolation sowie kompakte, vorzugsweise flache, Bauform und gute thermische Eigenschaften gewährleisten. Gleichzeitig bestehen Anforderungen nach geringen Kosten für Materialien und Prozesse bei gleichzeitig hoher Langzeitzuverlässigkeit und geringer Ausfallrate. Außerdem sollte ein großes Leistungsspektrum mit möglichst wenigen Modulvarianten realisierbar sein.

Die eigentlichen Leistungsbauelemente werden durch die Hersteller in Gehäuse eingebracht, wobei die Anschlüsse der Chips mit den äußeren Anschlüssen der Gehäuse verbunden werden. Für die integrierten Schaltkreise bzw. Chips der Informationstechnologie sind die Abmessungen solcher Gehäuse und die Anordnungen der Kontakte standardisiert, so dass die Produkte verschiedener Hersteller problemlos austauschbar sind. In der Leistungselektronik gibt es bisher keine standardisierten Gehäusebauformen.

Die Funktionalität eines neu zu entwickelnden Moduls soll durch die optimale Verknüpfung der mechanischen und elektronischen Komponenten, also die mechatronische Integration, erreicht werden. Die Teile der Applikation müssen für diese Integration zusammenwirken, d.h. die Stromleitung und Verteilung zu den Leistungsbauelementen bei gleichzeitiger Isolation der Bauelemente untereinander sowie die Entwärmung der Leistungsbauelemente bewerkstelligen. Darüber hinaus soll die Montage des Moduls einfach und zuverlässig möglich sein.

Die an sich geeigneten Leistungsbauelemente verschiedener Hersteller unterscheiden sich in ihren Gehäuseformen. Daher müssen alle diese Bauelemente einzeln auf ihre Eignung für die mechatronische Integration in das Modul geprüft werden. Das schließlich ausgewählte Leistungsbauelement verfügt im allgemeinen über ein aufwendiges Gehäuse und ist trotzdem noch nicht optimal für die mechatronische Integration in eine konkrete Applikation geeignet.

Ein häufiges Problem einer konkreten Lösung für ein Gesamtsystem ist, dass die Entwärmung der Leistungsbauelemente nicht optimal ist, weil die räumliche Auflösung der Verlustquellen nicht möglich ist. Häufig muss die Potentialtrennung zwischen den Schaltkreisen in den Leistungsbauelementen realisiert werden, was mehr Komponenten und komplex strukturierte Bauelemente erfordert. Dadurch wiederum büßt das Gesamtsystem an Robustheit ein, hat ein großes Bauvolumen und sein thermischer Widerstand (Rth) verschlechtert sich.

Insgesamt resultiert die Entwicklung jedes neuen Moduls in einer jeweils individuellen Lösung, bei der die Nachteile des Zusammenwirkens einer bestimmten Leistungsbauelement-Gehäuseform mit einer Applikation so gut wie möglich minimiert werden.

Die Aufgabe der Erfindung besteht also darin, eine Leistungsbauelementanordnung anzugeben, die für die mechatronische Integration verschiedener Leistungsbauelemente in die Applikation geeignet ist.

Diese Aufgabe wird durch eine Leistungsbauelementanordnung, mit den Merkmalen des Anspruchs 1 gelöst.

Eine erfindungsgemäße Leistungsbauelementanordnung weist eine Mehrzahl von Leistungsbauelementen, insbesondere IGBTs und/oder Leistungsdioden, auf, die auf einer Leiterplatte gehäusefrei angeordnet sind. Ferner umfasst die Anordnung wenigstens einen Kühlkörper zur Wärmeabführung von den Leistungsbauelementen und einen mit dem Kühlkörper verbundenen Druckmontagerahmen, der die auf der Leiterplatte angeordneten Leistungsbauelemente in Wärmeleitkontakt mit dem Kühlkörper hält.

Ein wesentlicher Gedanke der Erfindung besteht darin, von gehäusefreien Leistungsbauelementen auszugehen. Dadurch entfällt die Notwendigkeit, eine Leistungsbauelementanordnung für möglichst viele herkömmliche Gehäusebauformen auslegen zu müssen. Vielmehr kann die Leistungsbauelementanordnung zielstrebig auf mechanische, elektrische und thermische Anforderungen der konkreten Applikation hin optimiert werden.

Die Leistungsbauelemente können flexibel auf der Leiterplatte angeordnet werden, wodurch sich die Entwärmung optimieren lässt. Die Verbindung eines Leistungsbauelementes mit einem Kühlkörper zur Entwärmung erfolgt mittels eines Druckkontaktes, wodurch weitere Elemente zur Verbindung, beispielsweise eine angelötete Grundplatte, entfallen. Durch den Wegfall solcher Elemente wird der thermische Widerstand des Gesamtsystems kleiner. Deshalb ist die Zuverlässigkeit von mittels Druckkontakt-Technologie ausgeführten Leistungsmodulen höher.

Eine bevorzugte Anbringung eines Leistungsbauelementes auf der Leiterplatte erfolgt mittels eines Trägerstreifens, der mit dem Leistungsbauelement so verbunden ist, dass er einen mechanischen Träger für das Leistungsbauelement bildet. Er ist bevorzugt für die mechanische Verbindung mit der Leiterplatte mittels der SMD-Technik vorgesehen. Die Kontaktierung erfolgt mittels wenigstens zweier Anschlussstreifen, die jeweils mit einem der Kontakte des Leistungsbauelementes elektrisch verbunden und bevorzugt für die elektrische Verbindung mit der Leiterplatte mittels der SMD-Technik vorgesehen sind.

Im Gegensatz zur konventionellen Durchsteck-Technik IMT (Insert Mount Technology) werden SMD(Surface Mounted Devices)-Bauteile auf der Leiterplattenoberfläche aufgebracht und verlötet, ohne die Leiterplatte zur Befestigung zusätzlich durchbohren zu müssen. SMD-Komponenten sind wesentlich temperaturresistenter als bedrahtete Bauteile, außerdem zuverlässiger und darüber hinaus auch kostengünstiger und schneller zu verarbeiten.

Vorteile und Zweckmäßigkeiten der Erfindung ergeben sich im Übrigen aus den Unteransprüchen sowie der nachfolgenden Beschreibung eines bevorzugten Ausführungsbeispiels anhand der Figuren 1 bis 4.
- FIG 1: ist eine Explosionsdarstellung einer Leistungsbauelementanordnung.
- FIG 2: zeigt diese Ausführungsform aus einem anderen Blickwinkel, ebenfalls als Explosionsdarstellung.
- FIG 3: zeigt die Leistungsbauelementanordnung der FIG 1 und 2 in montiertem Zustand.
- FIG 4: zeigt in einer Detailansicht ein Einzelschaltelement mit einem Leistungsbauelement.

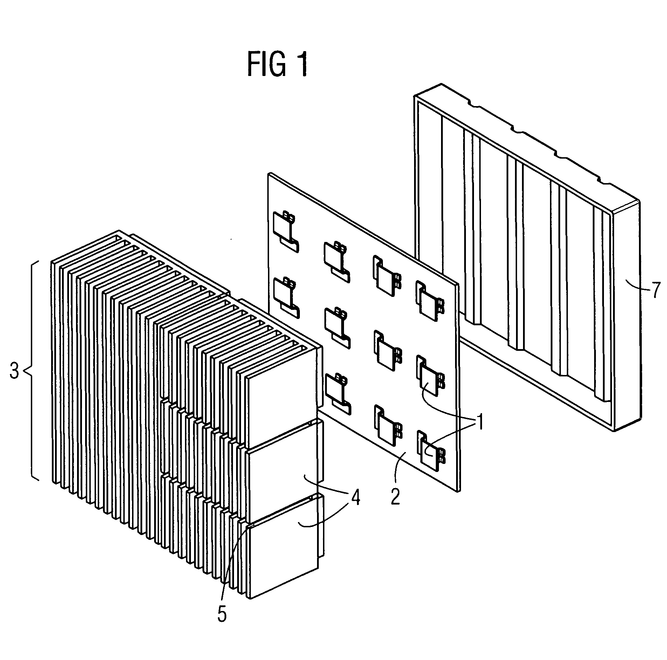

Die in den Figuren 1, 2 und 3 gezeigte erfindungsgemäße Leistungsbauelementanordnung weist als Leistungsbauelemente gehäusefreie IGBTs auf, die in zwölf Einzelschaltelemente 1 integriert sind. Diese sind auf einer Leiterplatte 2 angeordnet. Die Leiterplatte 2 weist (nicht gezeigte) Leiterbahnen zur Stromleitung und -verteilung zu, von und zwischen den Einzelschaltelementen 1 auf.

Jedes Einzelschaltelement 1 verfügt über drei Anschlussstreifen zur mechanischen und elektrischen Verbindung mit der Leiterplatte 2. Die Anschlussstreifen sind mittels der SMD-Technik an der Leiterplatte angebracht.

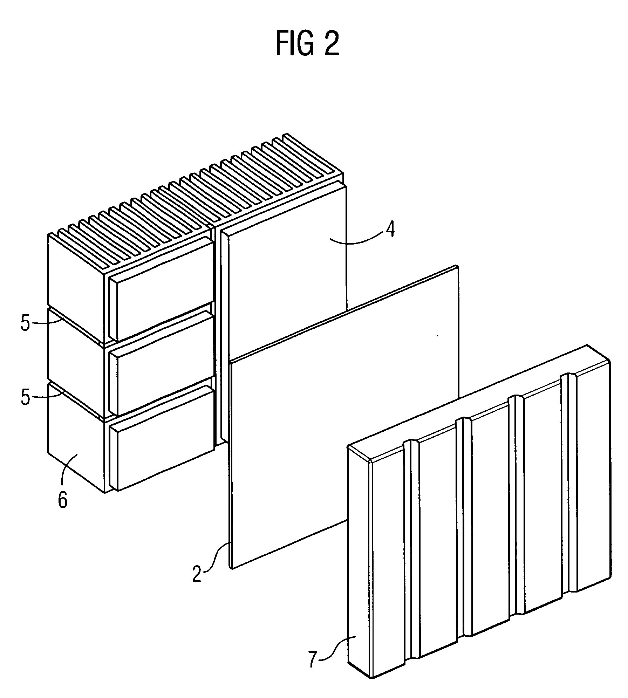

Zur Anordnung gehört ferner ein Kühlsystem 3, welches im wesentlichen aus einer Mehrzahl von Kühlkörpern 4 besteht. Da die Einzelschaltelemente 1 flexibel angeordnet werden können, kann eine Potentialtrennung in der Applikation durch getrennten Aufbau der Kühlkörper 4 durchgeführt werden. Die Kühlkörper 4 sind durch Lücken 5 galvanisch voneinander getrennt. In der FIG 2 ist gezeigt, dass die Kühlkörper gemeinsam mit einem isolierenden Material 6 zur Aufrechterhaltung der Lücken 5 das Kühlsystem bilden.

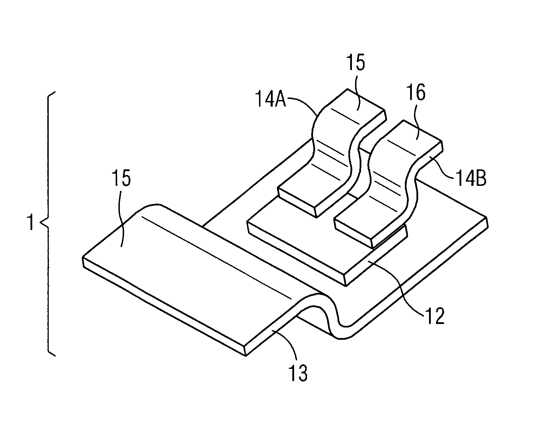

FIG 4 zeigt ein gehäusefreies Leistungsbauelement 12, das in ein Einzelschaltelement 1 integriert ist.

Das Einzelschaltelement 1 weist neben dem Leistungsbauelement 12 einen Trägerstreifen 13 und zwei Anschlussstreifen 14A, 14B auf. Das Leistungsbauelement 12 ist in diesem Ausführungsbeispiel ein IGBT und weist eine flach quaderförmige Grundform auf. Das Halbleiterbauelement 12 ist zur mechanischen Lagerung mit dem Trägerstreifen 13 verklebt.

Die Anschlüsse des Leistungsbauelementes 12 sind über (nicht gezeigte) Anschlussflächen, die einen Teil der Oberfläche des IGBT ausmachen, realisiert.

Die beiden Hauptanschlüsse befinden sich auf gegenüberliegenden Seiten des IGBT. Der eine Hauptanschluss des IGBT wird über die Fläche des Leistungsbauelementes 12 realisiert, die mit dem Trägerstreifen 13 leitfähig verklebt ist. Auf diese Weise dient der Trägerstreifen 13 sowohl zur mechanischen Lagerung des Leistungsbauelementes 12 als auch zur Kontaktierung eines Anschlusses.

Der zweite Hauptanschluss wird durch einen der Anschlussstreifen 14A kontaktiert. Der zweite der Anschlussstreifen 14B kontaktiert den Gateanschluss des IGBT 12.

Der Trägerstreifen 13 und die beiden Anschlussstreifen 14A, 14B weisen ein S-förmiges Profil auf und sind flächenhaft mit der Oberfläche der Leiterplatte 2 mittels SMD-Technik verbunden. Hierzu weisen der Trägerstreifen 13 und der Anschlussstreifen 14A jeweils eine Anschlussfläche 15 für einen Hauptanschluss, sowie der zweite Anschlussstreifen 14B eine Anschlussfläche 16 für den Gateanschluss auf.

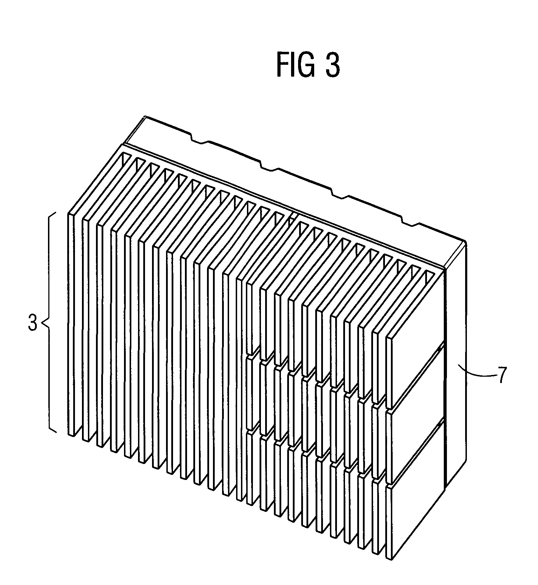

Ein Druckmontagerahmen 7 wird mit dem Kühlsystem 3 durch Einrasten verbunden, woraufhin die Leistungsbauelementanordnung eine Einheit bildet, wie sie in der FIG 3 gezeigt ist. Die Leiterplatte 2 befindet sich zwischen dem Kühlsystem 3 und dem Druckmontagerahmen 7. Die auf der Leiterplatte angeordneten Leistungsbauelemente 1 befinden sich in unmittelbarem thermischen Wärmeleitkontakt mit den Kühlkörpern 4: Der Trägerstreifen 13 ist zur Wärmeableitung von dem Leistungsbauelement 12 an einen der Kühlkörper 4 ausgebildet, der flächenhaft die gegenüberliegende Seite desjenigen Teiles des Trägerstreifens 13, der das Leistungsbauelement 12 trägt, berührt. Zur optimalen Wärmeableitung übertreffen die Hauptabmessungen des Trägerstreifens 13 die Hauptabmessungen des Leistungsbauelementes 12.

Bei einer (nicht gezeigten) alternativen Ausführungsform ist die die Leistungsbauelemente 1 tragende Seite der Leiterplatte 2 von dem Kühlsystem 3 abgewandt. In diesem Falle sind der Trägerstreifen 13 und die Anschlussstreifen 14A, 14B zur Wärmeableitung von dem Leistungsbauelement 12 über die Anschlussflächen 15, 16 auf die Leiterplatte 2 ausgebildet, die ihrerseits zur Wärmeableitung von den Anschlussflächen 15, 16 zu den Kühlkörpern 4, die sie flächenhaft berührt, ausgebildet ist.

Die Ausführung der Erfindung ist nicht auf dieses Beispiel beschränkt, sondern im Rahmen der anhängenden Ansprüche auch in einer Vielzahl von Abwandlungen möglich, die im Rahmen fachgemäßen Handelns liegen.

## Patentansprüche

1. Leistungsbauelementanordnung zur mechatronischen Integration von Leistungsbauelementen, mit einer Mehrzahl von Leistungsbauelementen, insbesondere IGBTs und/oder Leistungsdioden, einer Leiterplatte, auf der die Leistungsbauelemente gehäusefrei angeordnet sind, mindestens einem Kühlkörper zur Wärmeabführung von den Leistungsbauelementen und einem mit dem Kühlkörper verbundenen Druckmontagerahmen, der die auf der Leiterplatte angeordneten Leistungsbauelemente in Wärmeleitkontakt mit dem Kühlkörper hält.

2. Leistungsbauelementanordnung nach Anspruch 1,
**dadurch gekennzeichnet, dass** Druckmontagerahmen und Kühlkörper durch Rastmittel miteinander verbunden sind.

3. Leistungsbauelementanordnung nach Anspruch 1,
**dadurch gekennzeichnet, dass** Druckmontagerahmen und Kühlkörper durch eine Schraubverbindung miteinander verbunden sind.

4. Leistungsbauelementanordnung nach einem der vorhergehenden Ansprüche, **dadurch gekennzeichnet, dass** eine Mehrzahl von Kühlkörpern vorgesehen ist, die galvanisch voneinander getrennt sind.

5. Leistungsbauelementanordnung nach einem der vorangehenden Ansprüche, **gekennzeichnet durch** Leistungsbauelemente, die jeweils auf einem Trägerstreifen, der mechanisch mit der Leiterplatte verbunden ist, gehäusefrei mechanisch gelagert sind, und wenigstens zwei Anschlussstreifen für jedes Leistungsbauelement, die jeweils mit einem elektrischen Kontakt des Leistungsbauelementes verbunden sind und elektrisch mit der Leiterplatte verbunden sind.

6. Leistungsbauelementanordnung nach Anspruch 5,
**dadurch gekennzeichnet, dass** der Trägerstreifen zur mechanischen Verbindung mit der Leiterplatte mittels SMD-Technik ausgebildet ist, und die Anschlussstreifen zur elektrischen Verbindung mit der Leiterplatte mittels SMD-Technik vorgesehen sind.

7. Leistungsbauelementanordnung nach Anspruch 5 oder 6,
**dadurch gekennzeichnet, dass** der Trägerstreifen und/oder die Anschlussstreifen zur Wärmeableitung von dem Leistungsbauelement ausgebildet ist bzw. sind.

8. Leistungsbauelementanordnung nach einem der Ansprüche 5 bis 7, **dadurch gekennzeichnet, dass** der Trägerstreifen und/oder die Anschlussstreifen mit dem Leistungsbauelement verklebt oder verlötet ist bzw. sind.

9. Leistungsbauelementanordnung nach einem der Ansprüche 5 bis 8, **dadurch gekennzeichnet, dass** die Hauptabmessungen des Trägerstreifens den Hauptabmessungen des Leistungsbauelementes entsprechen oder diese übertreffen.

10. Leistungsbauelementanordnung nach einem der Ansprüche 5 bis 9, **dadurch gekennzeichnet, dass** die Trägerstreifen und/oder die Anschlussstreifen ein S-förmiges Profil aufweisen.
